# EUROPÄISCHE PATENTANMELDUNG

(11) **EP 3 012 342 A1**
(43) Veröffentlichungstag der Anmeldung: **27.04.2016**
(21) Anmeldenummer: 15190970.2
(22) Anmeldetag: 22.10.2015
(51) Int. Cl.: C23C 4/134, B22F 1/00, H01J 37/32, H05H 1/44

(54) **THERMISCHES SPRITZVERFAHREN UND VORRICHTUNG DAFÜR**

(30) Priorität: 24.10.2014 DE 102014221735
(71) Anmelder: MAHLE International GmbH, 70376 Stuttgart (DE)
(72) Erfinder: Englert, Peter, 74177 Bad Friedrichshall (DE); Mamber, Dr. Oliver, 71706 Markgröningen (DE); Trautwein, Ingo, 74321 Bietigheim-Bissingen (DE); Rodriguez, Tomas, 70374 Stuttgart (DE)
(74) Vertreter: Grauel, Andreas

(57) **Zusammenfassung**

Die Erfindung betrifft ein thermisches Spritzverfahren insbesondere zum Beschichten einer Oberfläche (4) mittels eines Plasmastrahls, unter Verwendung eines geformten Plasmastrahls (3), wobei ein erster Plasmastrahl (1) mittels wenigstens eines zweiten Plasmastrahls (2) gesteuert und/oder geformt wird, wobei der zweite Plasmastrahl (2) den ersten Plasmastrahl (1) wenigstens teilweise und wenigstens zeitweise durchdringt.

## Beschreibung

### Technisches Gebiet

Die Erfindung betrifft ein thermisches Spritzverfahren und eine Vorrichtung zum thermischen Spritzen zum Beschichten einer Oberfläche mittels eines geformten Plasmastrahls. Insbesondere betrifft die Erfindung auch die Anwendung eines solchen Verfahrens.

### Stand der Technik

Zur Beschichtung von Oberflächen sind thermische Spritzverfahren geeignet. Dabei werden Zusatzwerkstoffe, die so genannten Spritzzusätze, innerhalb oder außerhalb eines Spritzbrenners ab-, an- oder aufgeschmolzen, in einem Gasstrom in Form von Spritzpartikeln beschleunigt und auf die Oberfläche des zu beschichtenden Bauteils geschleudert. Die Bauteiloberfläche wird dabei im Gegensatz zum Auftragsschweißen nicht angeschmolzen und nur in geringem Maße thermisch belastet. Eine Schichtbildung findet statt, weil die Spritzpartikel beim Auftreffen auf die Bauteiloberfläche prozess- und materialabhängig mehr oder minder abflachen, vorrangig durch mechanische Verklammerung haften bleiben und lagenweise die Spritzschicht aufbauen. Als Energieträger für die An- oder Aufschmelzung des Spritzzusatzwerkstoffes kommt unter anderem ein Plasmastrahl beim so genannten Plasmaspritzen in Betracht. Die EP 1 871 921 A1 offenbart ein solches Verfahren.

Ein typischer Plasmastrahl ist nicht breit gefächert, sondern eher schmal und spitz zulaufend ausgebildet. Dadurch kann immer nur ein entsprechend schmaler Streifen auf einer Oberfläche beschichtet werden. Außerdem führt das Eindüsen von Pulvern zur Beschichtung, wie beispielsweise eines Flussmittelpulvers bei der Herstellung von Hartlötbauteilen, zu einer Inhomogenität des Plasmastrahls und/oder zu Pulsen im Plasmastrahl und gegebenenfalls auch zu einer Abnahme der im Plasma enthaltenen Energie. Dies führt zu einem ungenügenden Aufschmelzen des Pulvers im Plasma und dadurch zu einer unzureichenden Anhaftung auf einer zu beschichtenden Metalloberfläche.

Wird außerdem ein schnelllaufendes dünnes Metallband mit einer Geschwindigkeit von 20 bis 300 m/min mit einem thermischen Spritzverfahren, insbesondere mit einem Plasmaspritzverfahren, beschichtet, verformt sich der Plasmajet häufig in Laufrichtung des Bandes. Wird dabei eine Bandbeschichtung mit einer höherenergetischen Plasmabeschichtungseinrichtung mit Leistungen von mehr als 20kW durchgeführt, um die oben genannten energetischen Schwankungen zu kompensieren, wird die kinetische Energie rasch so hoch, dass es zu einer Beschädigung oder Verformung der dünnen Metallbänder kommen kann.

Eine Kontrolle des Plasmajets und damit auch die Möglichkeit einer Formung des Plasmajets erfolgt gemäß dem Stand der Technik mithilfe von starken Magnetfeldern oder auch durch Anblasen mit Gasen oder mit Druckluft. Auch für kleine Plasmajetgeometrien sind bereits hohe magnetische Feldstärken erforderlich. Die dafür notwendigen elektrischen Generatoren zur Erzeugung der benötigten Stromstärken für die Erzeugung des Magnetfelds sind kostenintensiv und energetisch nicht zielführend.

In Versuchen hat sich auch noch gezeigt, dass mit den verfügbaren Magnetfeldstärken keine signifikante Beeinflussung eines Plasmajets erzielt werden kann. Weiterhin haben eigene Untersuchungen gezeigt, dass sich ein Plasmastrahl wie eine sehr hochviskose Flüssigkeit verhält; damit ist eine hinreichende Beeinflussung mit einem niederviskosen Medium wie Druckluft nicht darstellbar.

### Darstellung der Erfindung, Aufgabe, Lösung, Vorteile

Es ist die Aufgabe der Erfindung, ein thermisches Spritzverfahren mit einem Plasmastrahl zu schaffen, bei welchem die oben genannten Nachteile möglichst reduziert oder vermieden werden können. Auch ist es die Aufgabe eine Vorrichtung zur Durchführung eines thermischen Spritzverfahrens zu schaffen, mittels welchem ein verbessertes thermisches Spritzverfahren durchführbar ist.

Diese Aufgabe wird durch ein thermisches Spritzverfahren bzw. eine Vorrichtung mit den Merkmalen von Anspruch 1 oder von Anspruch 7 bzw. 12 gelöst. Vorteilhafte Weiterbildungen der Erfindung ergeben sich aus den abhängigen Ansprüchen.

Ein Ausführungsbeispiel der vorliegenden Erfindung betrifft ein thermisches Spritzverfahren zum Beschichten einer Oberfläche mittels eines Plasmastrahls wobei ein erster Plasmastrahl mittels wenigstens eines zweiten Plasmastrahls zu dem Plasmastrahl vereint und/oder geformt wird, wobei der zweite Plasmastrahl den ersten Plasmastrahl wenigstens teilweise und wenigstens zeitweise durchdringt.

Im vorliegenden Zusammenhang soll unter einem Plasmastrahl oder auch unter einem Plasmajet ein strömendes Gas oder Gasgemisch verstanden werden, das durch Energiezufuhr wenigstens teilweise ionisiert ist. Die Energiezufuhr erfolgt dabei vorzugsweise auf elektromagnetischem Wege, also beispielsweise mithilfe eines hochfrequenten Wechselstroms, der das Gas induktiv aufheizt. Andere Möglichkeiten der Energiezufuhr sind beispielsweise Anregungen durch ultraviolettes Licht, andere ionisierende Strahlen, durch Lichtbögen und/oder durch Gasentladungen. Ein solches Plasma befindet sich in der Regel nicht im thermischen Gleichgewicht, da die Elektronen in einem Plasma regelmäßig eine weit höhere Energie aufweisen als die Ionen. Bei technisch hergestellten Niederdruckplasmen liegt der Grad der Ionisierung allerdings maximal bei wenigen Promille.

Zwei Plasmastrahlen durchdringen sich im Sinne der vorliegenden Erfindung wenigstens teilweise und wenigstens zeitweise, wenn die Teilchen, die die beiden Plasmastrahlen konstituieren, sich wenigstens teilweise zu einem gemeinsamen Plasma durchmischen und/oder vereinigen.

Bevorzugt ist es, wenn der aus dem ersten Plasmastrahl und dem zweiten Plasmastrahl resultierende Plasmastrahl einen breiteren und homogeneren Plasmajet aufweist, im Vergleich zu dem ersten und dem zweiten Plasmastrahl.

Dabei ist es vorteilhaft, wenn der wenigstens eine zweite Plasmastrahl in einem vorgebbaren Winkel zu dem ersten Plasmastrahl ausgerichtet wird, wobei der Winkel ungleich 0 oder 180° sein wird.

Auch ist es bevorzugt, wenn der wenigstens eine zweite Plasmastrahl in einem vorgebbaren Winkel zwischen 15 und 45 Grad zu dem ersten Plasmastrahl ausgerichtet wird. Erfahrungsgemäß ist so eine gute Steuerung und/oder Formung des Plasmastrahls möglich. Andere Ausrichtungen der Plasmastrahlen können bei bestimmten Anwendungen ebenfalls vorteilhaft sein.

Dabei ist es bevorzugt, wenn der wenigstens eine zweite Plasmastrahl nicht parallel zu dem ersten Plasmastrahl ausgerichtet ist. Unter der Ausrichtung eines Plasmastrahls soll hier die Richtung des mittleren Geschwindigkeitsvektors der strömenden Teilchen verstanden werden.

Zur Erzeugung einer Beschichtung auf einer Oberfläche ist es bevorzugt, wenn dem ersten Plasmastrahl ein Beschichtungspulver zugesetzt wird. Der erste Plasmastrahl wird mithilfe wenigstens eines zweiten Plasmastrahls gesteuert und/oder geformt, wobei der zweite Plasmastrahl den ersten Plasmastrahl wenigstens teilweise und wenigstens zeitweise durchdringt. Dadurch wird der Plasmastrahl mit Zusatz des Beschichtungspulvers geformt.

Erfindungsgemäß ist es ist es vorteilhaft, wenn die Oberfläche eine Oberfläche eines laufenden Bandes ist, und der zweite Plasmastrahl entgegen der Laufrichtung des zu beschichtenden laufenden Bandes ausgerichtet wird. Dies führt dazu, dass eine Ablenkung des ersten Plasmastrahls durch das laufende Band wenigstes teilweise vermieden, verringert oder beseitigt wird. Der vereinigte Plasmastrahl wird dann wenigstens weniger abgelenkt als der erste Plasmastrahl.

In einem anderen Ausführungsbeispiel betrifft die Erfindung eine Vorrichtung zur Durchführung eines thermischen Spritzverfahrens mittels eines Plasmastrahls, mit einer ersten Quelle für einen ersten Plasmastrahl, gekennzeichnet durch eine zweite Quelle für einen zweiten Plasmastrahl, die derart anordenbar ist, dass der zweite Plasmastrahl den ersten Plasmastrahl wenigstens teilweise und wenigstens zeitweise durchdringt, so dass dadurch der Plasmastrahl erzeugbar ist.

Dabei ist es bevorzugt, wenn der wenigstens eine zweite Plasmastrahl in einem vorgebbaren Winkel zu dem ersten Plasmastrahl ausrichtbar ist, wobei der Winkel ungleich 0 oder 180° ist.

Auch ist es vorteilhaft, wenn der wenigstens eine zweite Plasmastrahl in einem Winkel zwischen 15 und 45 Grad zu dem ersten Plasmastrahl ausrichtbar ist.

Auch ist es bei einem weiteren Ausführungsbeispiel vorteilhaft ist, wenn eine Pulverzuführung zur Zufuhr eines zur Beschichtung vorgesehen Pulvers zu dem ersten Plasmastrahl vorgesehen ist.

Ebenso ist es vorteilhaft, wenn die Oberfläche die Oberfläche eines zu beschichtenden laufenden Bandes ist, und dass der zweite Plasmastrahl entgegen der Laufrichtung des Bandes ausrichtbar ist.

Bei einem weiteren Ausführungsbeispiel gemäß der Erfindung ist eine Vorrichtung zur Steuerung oder Regelung der Einstellung einer ersten Quelle und einer zweiten Quelle vorgesehen zur Erzeugung eines Plasmastrahls, bei welcher Einstellung der ersten Quelle und/oder der zweiten Quelle derart vorgenommen wird, so dass ein Plasmastrahl aus einem ersten Plasmastrahl der ersten Quelle und aus einem zweiten Plasmastrahl der zweiten Quelle resultiert, welcher vorgebbare Eigenschaften, insbesondere hinsichtlich Breite und Homogenität, aufweist.

Weitere vorteilhafte Ausgestaltungen sind durch die nachfolgende Figurenbeschreibung und durch die Unteransprüche beschrieben.

### Kurze Beschreibung der Figuren der Zeichnung

Nachstehend wird die Erfindung auf der Grundlage zumindest eines Ausführungsbeispiels anhand der Figuren der Zeichnung näher erläutert. Es zeigt:
- Figur 1: eine schematische Darstellung eines bevorzugten Ausführungsbeispiels einer erfindungsgemäßen Vorrichtung, und
- Figur 2: eine schematische Darstellung eines weiteren Ausführungsbeispiels.

### Bevorzugte Ausführung der Erfindung

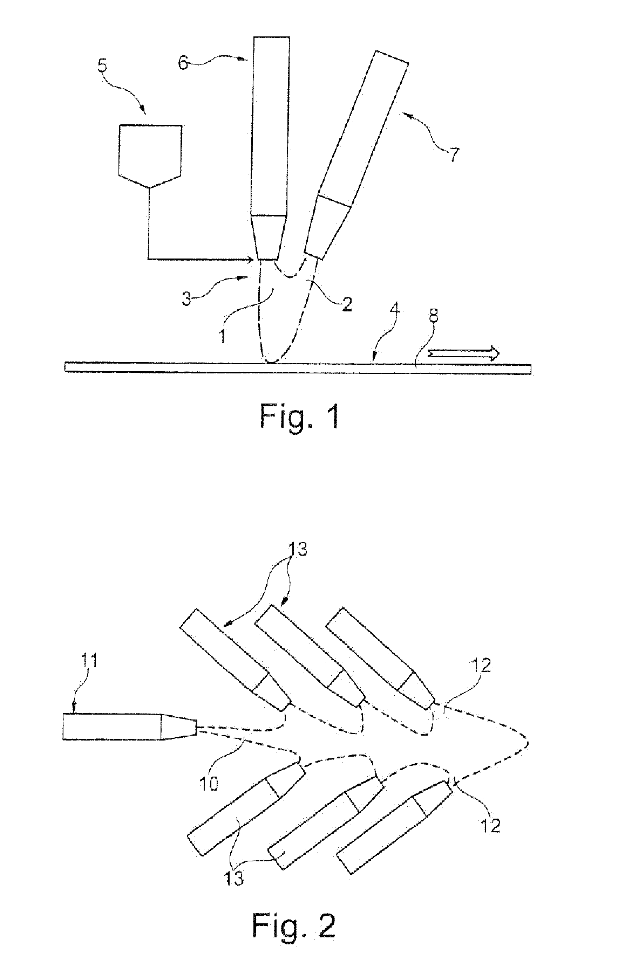

Figur 1 zeigt eine erste Quelle 6 eines ersten Plasmastrahls 1, vorzugsweise einen sogenannten Plasmabrenner 1, und eine zweite Quelle 7 eines zweiten Plasmastrahls 2, vorzugsweise einen weiteren zweiten Plasmabrenner, deren Plasmastrahlen 1, 2 sich zu einem fusionierten oder gemeinsamen Plasmastrahl 3 vereinen. Dem ersten Plasmastrahl 1 wird durch eine Pulverzuführung 5 ein Pulver zugeführt, mit dem die Oberfläche 4 eines nach rechts laufenden Bandes 8, beschichtet werden soll. Das Band 8 ist vorzugsweise ein Metallband.

Experimentell konnte gezeigt werden, dass der erste Plasmastrahl 1 durch einen zweiten Plasmastrahl 2 beeinflusst, d.h. insbesondere geformt und/oder gesteuert werden kann, und dass sich dabei beide Strahlen 1, 2, die auch Plasmajets genannt werden, homogen zu einem gemeinsamen Plasmastrahl 3 vereinen. Der erste Plasmastrahl 1 lässt sich mit einem zweiten seitlich angeordneten Plasmastrahl 2 formen, steuern und/oder geometrisch verändern.

Interessanterweise werden zwei sich kreuzende Plasmajets 1, 2 nicht zerstäubt, wie es bei zwei sich kreuzenden Flüssigkeitsstrahlen bekannt ist, sondern sie vereinen sich zu einem breiteren homogeneren Plasmajet 3. Dieser Effekt bietet nun die Möglichkeit, eine Plasmapulverbeschichtung deutlich verbessert darzustellen.

In einer bevorzugten Ausführung wird einem ersten Plasmastrahl 1 ein Beschichtungspulver 5 zugesetzt. Diesem ersten Plasmastrahl 1 wird nun seitlich in einem Winkel, der vorzugsweise zwischen 15 und 45 Grad liegt, ein zweiter Plasmastrahl 2 zugeführt. Es kommt dann zu einer homogenen Vereinigung 3 der beiden Plasmastrahlen 1, 2.

Dieser neue doppelte Plasmastrahl 3 ist nun deutlich homogener und breiter als die mit Beschichtungspulvern 5 beschickten Ursprungsstrahlen alleine.

Es hat sich gezeigt, dass dadurch das Spritzpulver homogener auf die Oberfläche 4 aufgebracht wird. Der entstandene breitere Plasmastrahl 3 führt zu einer breiteren Beschichtungsfläche.

Wird nun der zweite Plasmastrahl 2 entgegen der Laufrichtung eines schnelllaufenden, zu beschichtenden Metallbandes angebracht, kann verhindert werden, dass der Plasmastrahl der Bandlaufrichtung nachfolgt. Für die Beschichtung eines schnelllaufenden Metallbandes ist es nun möglich, einem ersten Plasmastrahl 1 eine hohe Pulvermenge zuzusetzen. Der Plasmastrahl 1 wird dadurch zunächst zwar inhomogener und instabiler, durch einen oder mehrere seitlich angeordnete treibende Plasmastrahlen 2 wird diesem ersten Pulverplasmastrahl 1 allerdings so viel Energie zugeführt, dass das Pulver länger im gesamten Strahl 3 geschmolzen bleibt.

Der gesamte Plasmastrahl 3 ist nun thermisch energiereicher, homogener und erzeugt ein deutlich homogeneres Beschichtungsergebnis. Gleichzeitig erlaubt ein solchermaßen kombinierter Plasmastrahl 3 einen höheren Pulverdurchsatz und ermöglicht eine breitere Beschichtungsfläche.

Die kinetische Energie ist aber geringer als bei einem vergleichbaren hochenergetischen (> 20 kW) Plasmabeschichtungssystem. Somit kann ein fusionierter Plasmajet 3 mit einem höheren thermischen Energieinhalt aber mit einer geringeren kinetischen Energie erzeugt werden. Der Abstand des vereinten Plasmastrahls 3 von der Bandoberfläche 4 kann damit vergrößert werden, wodurch elektrische Überschläge und Beschädigungen auf der Bandoberfläche nun ausgeschlossen oder weitgehend vermieden werden können.

Ausführungsformen eines erfindungsgemäßen Verfahrens und/oder einer erfindungsgemäßen Vorrichtung eignen sich in vorteilhafter Weise zur Beschichtung von Bauteilen, insbesondere von Aluminiumbauteilen mit einem Flussmittelpulver zur Hartlötung.

Für die Hartlötung von Aluminiumbauteilen, insbesondere von Wärmeübertragern aus Aluminium, werden hauptsächlich sogenannte Flussmittel eingesetzt. Für dieses Hartlötvorverfahren haben sich spezielle fluoridhaltige Flussmittel, die unter dem Handelsnamen NOCOLOK vertrieben werden, als primär verwendete Technologie durchgesetzt.

Das Flussmittel schmilzt kurz vor dem Lot, reinigt die Oberflächen, die verlötet werden sollen, und stellt eine metallisch blanke Oberfläche her, die das flüssige Lot benötigt, um benetzen und binden zu können. In vielen Anwendungsfällen können die daraus resultierenden Flussmittelreste auf dem Bauteil verbleiben, da sie für die Werkstoffe nicht schädlich, insbesondere nicht korrosiv, wirken.

Jedoch zeigen Erfahrungen und Untersuchungen, dass einerseits die Kühlflüssigkeiten durch Flussmittelreste nachteilig beeinflusst werden können, und dass es andererseits in Rohren, die konstruktiv bedingt enge Querschnitte aufweisen, zu einer Querschnittsverringerung durch Flussmittelreste kommen kann. Deshalb ist eine Minimierung des Flussmitteleintrages wünschenswert. Ideal wäre eine gezielte Flussmittelapplikation ausschließlich an den zu lötenden Stellen. Dies wird durch die vorliegende Erfindung ermöglicht.

Die Figur 2 zeigt, wie ein Plasmastrahl 10 einer Plasmaquelle 11 mittels einer Mehrzahl anderer Plasmastrahlen 12 anderer Plasmaquellen 13 gesteuert wird.

## Patentansprüche

1. Thermisches Spritzverfahren zum Beschichten einer Oberfläche (4) mittels eines Plasmastrahls (3), **dadurch gekennzeichnet, dass** ein erster Plasmastrahl (1) mittels wenigstens eines zweiten Plasmastrahls (2) zu dem Plasmastrahl (3) vereint und/oder geformt wird, wobei der zweite Plasmastrahl (2) den ersten Plasmastrahl (1) wenigstens teilweise und wenigstens zeitweise durchdringt.

2. Thermisches Spritzverfahren nach Anspruch 1, **dadurch gekennzeichnet, dass** der aus dem ersten Plasmastrahl (1) und dem zweiten Plasmastrahl (2) resultierende Plasmastrahl (3) einen breiteren und homogeneren Plasmajet aufweist, im Vergleich zu dem ersten und dem zweiten Plasmastrahl (1,2).

3. Thermisches Spritzverfahren nach Anspruch 1 oder 2, **dadurch gekennzeichnet, dass** der wenigstens eine zweite Plasmastrahl (2) in einem vorgebbaren Winkel zu dem ersten Plasmastrahl (1) ausgerichtet wird, wobei der Winkel ungleich 0 oder 180° wird.

4. Thermisches Spritzverfahren nach Anspruch 3, **dadurch gekennzeichnet, dass** der wenigstens eine zweite Plasmastrahl (2) in einem vorgebbaren Winkel zwischen 15 und 45 Grad zu dem ersten Plasmastrahl (1) ausgerichtet wird.

5. Thermisches Spritzverfahren nach einem der Ansprüche 1 bis 4,
**dadurch gekennzeichnet, dass** dem ersten Plasmastrahl (1) ein Beschichtungspulver (5) zugesetzt wird.

6. Thermisches Spritzverfahren nach Anspruch 4, **dadurch gekennzeichnet, dass** die Oberfläche (4) eine Oberfläche eines laufenden Bandes (8) ist, und der zweite Plasmastrahl (2) entgegen der Laufrichtung des zu beschichtenden laufenden Bandes (8) ausgerichtet wird.

7. Vorrichtung zur Durchführung eines thermischen Spritzverfahrens mittels eines Plasmastrahls (3), mit einer ersten Quelle (6) für einen ersten Plasmastrahl (1), **gekennzeichnet durch** eine zweite Quelle (7) für einen zweiten Plasmastrahl (2), die derart anordenbar ist, dass der zweite Plasmastrahl (2) den ersten Plasmastrahl (1) wenigstens teilweise und wenigstens zeitweise durchdringt, so dass **dadurch** der Plasmastrahl (3) erzeugbar ist.

8. Vorrichtung nach Anspruch 7, **dadurch gekennzeichnet, dass** der wenigstens eine zweite Plasmastrahl (2) in einem vorgebbaren Winkel zu dem ersten Plasmastrahl (1) ausrichtbar ist, wobei der Winkel ungleich 0 oder 180° ist.

9. Vorrichtung nach Anspruch 8, **dadurch gekennzeichnet, dass** der wenigstens eine zweite Plasmastrahl (2) in einem Winkel zwischen 15 und 45 Grad zu dem ersten Plasmastrahl (1) ausrichtbar ist.

10. Vorrichtung nach einem der Ansprüche 7 bis 9, weiterhin
**gekennzeichnet durch** eine Pulverzuführung (5) zur Zufuhr eines zur Beschichtung vorgesehen Pulvers zu dem ersten Plasmastrahl (1).

11. Vorrichtung nach Anspruch 10, **dadurch gekennzeichnet, dass** das die Oberfläche (4) die Oberfläche eines zu beschichtenden laufenden Bandes (8) ist, und dass der zweite Plasmastrahl (2) entgegen der Laufrichtung des Bandes (8) ausrichtbar ist.

12. Vorrichtung zur Steuerung oder Regelung der Einstellung einer ersten Quelle und einer zweiten Quelle, insbesondere gemäß einem der vorhergehenden Ansprüche 7 bis 11, zur Erzeugung eines Plasmastrahls, bei welcher Einstellung der ersten Quelle und/oder der zweiten Quelle derart vorgenommen wird, so dass ein Plasmastrahl aus einem ersten Plasmastrahl der ersten Quelle und aus einem zweiten Plasmastrahl der zweiten Quelle resultiert, welcher vorgebbare Eigenschaften, insbesondere hinsichtlich Breite und Homogenität, aufweist.
